# EUROPÄISCHE PATENTSCHRIFT

(11) **EP 3 289 618 B1**
(45) Veröffentlichungstag und Bekanntmachung des Hinweises auf die Patenterteilung: **23.09.2020**
(21) Anmeldenummer: 16711996.5
(22) Anmeldetag: 11.03.2016
(51) Int. Cl.: H01L 33/50, H01L 25/075, H01L 33/60

(54) **LED-MODUL ZUR ABGABE VON WEISSLICHT**
LED MODULE FOR EMITTING WHITE LIGHT
MODULE DE DEL POUR ÉMISSION DE LUMIÈRE BLANCHE

(30) Priorität: 29.04.2015 DE 102015207934
(43) Veröffentlichungstag der Anmeldung: 07.03.2018
(73) Patentinhaber: Tridonic GmbH & Co. KG, 6850 Dornbirn (AT)
(72) Erfinder: PACHLER, Peter, 8042 Graz (AT); BORSOI, Giulio, 6850 Dornbirn (AT)
(74) Vertreter: Rupp, Christian
(86) Internationale Anmeldenummer: PCT/EP2016/055342
(87) Internationale Veröffentlichungsnummer: WO 2016/173761

(56) Entgegenhaltungen:
- EP-A1- 2 717 338
- WO-A1-2015/110875
- JP-A- 2008 218 485
- JP-A- 2014 049 504
- US-A1- 2013 069 527

## Beschreibung

### 1. Gebiet der Erfindung

Die vorliegende Erfindung betrifft ein LED-Modul (Leuchtdioden-Modul) zur Abgabe von Mischlicht, vorzugsweise von Weißlicht. Weiterhin betrifft die vorliegende Erfindung ein Verfahren zur Herstellung eines LED-Moduls und eine Leuchtvorrichtung mit zumindest einem solchen LED-Modul.

### 2. Hintergrund

Aus dem Stand der Technik sind LED-Module bekannt, die zur Abgabe von Mischlicht geeignet sind, insbesondere von Weißlicht. Diese LED-Module weisen in der Regel ein lichtabstrahlendes Lichtfeld auf, das durch eine Kombination einzelner Lichtpunkte gebildet wird. Die einzelnen Lichtpunkte sind dazu ausgelegt, unterschiedliche Lichtspektren abzugeben. Beispielsweise wird von den Lichtpunkten blaues Licht, rotes Licht und von einem Leuchtstoff erzeugtes gelbes Licht abgegeben. Die Lichtpunkte werden typischerweise mit einem sogenannten Globe-Top Verfahren gebildet, bei dem Dispenstropfen direkt auf die einzelnen LED-Chips aufgebracht werden. Solche LED-Module weisen allerdings ein zu großes Lichtfeld auf, um damit Leuchten mit vergleichsweise kleinen Reflektorgrößen auszustatten. Solche LED-Module weisen allerdings ein im Vergleich zu nicht steuerbaren Lichtquellen ein relativ großes Lichtfeld auf und das Licht muss zudem in einer Mischkammer homogenisiert werden was zusätzlichen Bauraum erfordert und was dazu führt, dass Leuchten einen den ästhetischen Ansprüchen ungenügend großen Reflektor benötigen. Derartige Lichtfelder, wenn diese kostengünstig und mit hoher Effizienz hergestellt werden sollen, weisen typischerweise einen Durchmesser von wenigstens 19 mm (unter der Annahme von etwa 2000+lm Lichtstrom) auf, wobei es mit den bekannten Globe-Top Verfahren grundsätzlich nicht möglich ist den Durchmesser des Lichtfelds weiter zu verringern.

Ferner sind beispielsweise aus der Druckschrift EP 2 738 825 A1 LED-Module mit einem Lichtfeld bekannt, in denen verschiedene Bereiche durch eine integral ausgebildete Zwischenwandung voneinander abgetrennt werden. Die Druckschrift EP 2 717338 A1 offenbart ein LED-Modul zur Abgabe von Mischlicht mit mehreren Leuchtabschnitten, die aus Leuchtdioden mit einem fluoreszierenden Harz bestehen.

Im Lichte dieses Standes der Technik ist es Aufgabe der vorliegenden Erfindung, ein LED-Modul und ein Verfahren zur Herstellung eines LED-Moduls zur Abgabe von Mischlicht, vorzugsweise ein (Misch-)Weißlicht, bereitzustellen, das den bekannten Stand der Technik verbessert. Insbesondere sollen LED-Module bereitgestellt werden können, die sich besonders gut zum Einsatz in steuerbaren Operationsleuchten (OP-Leuchten) oder in dimmbaren Leuchten für Wohnräume eignen.

Diese und andere Aufgaben, die beim Lesen der folgenden Beschreibung noch genannt werden oder vom Fachmann erkannt werden können, werden durch den Gegenstand der unabhängigen Ansprüche gelöst. Die abhängigen Ansprüche bilden den zentralen Gedanken der vorliegenden Erfindung in besonders vorteilhafterweise weiter.

### 3. Ausführliche Beschreibung der Erfindung

Ein erfindungsgemäßes LED-Modul zur Abgabe von Mischlicht, vorzugsweise von Weißlicht, umfasst: zumindest die Merkmale gemäß Anspruch 1.

Mit anderen Worten schlägt die vorliegende Erfindung vor, ein Lichtfeld eines LED-Moduls durch voneinander getrennte, wulstförmige Wandungen in unterschiedliche voneinander abgetrennte Bereiche zu unterteilen. Unter einem wulstförmigen Wandungsabschnitt ist dabei ein Wandungsabschnitt mit einer halbkreisförmigen Querschnittsform zu verstehen. Derartige wulstförmige Wandungen können auf einfache Weise mittels eines sogenannten Dispensverfahrens aufgebracht werden, so dass dadurch die abgetrennten Bereiche auf einfache Weise bereitgestellt werden können. In die verschiedenen voneinander abgetrennten Bereiche können dabei Vergussmassen mit identischen Leuchtstoff bzw. einer identischen Leuchtstoffmischung eingebracht werden oder es können Vergussmassen mit unterschiedlichen Leuchtstoffen bzw. unterschiedlichen Leuchtstoffmischungen in die verschiedenen voneinander abgetrennten Bereiche eingebracht werden. Je nach Einsatzgebiet des LED-Moduls können LED-Chips sowohl im Bereich der durch die wulstförmigen Wandungen abgetrennten Bereiche des Lichtfelds als auch im Bereich der wulstförmigen Wandungen selbst angeordnet sein.

Vorteilhafterweise ist die Vergussmasse eine Vergussmasse auf Silikon- und/oder Epoxidbasis, welche in den für die Funktion wichtigen spektralen Bereichen vorzugsweise bereits im flüssigen, zumindest jedoch im vernetzten Zustand vollständig transparent ist.

Vorzugsweise weist der Damm (bzw. die Dämme) eine in Draufsicht gesehene Breite zwischen 50 µm und 2 mm auf, besonders bevorzugt zwischen 300 µm und 1,5 mm und weiter bevorzugt zwischen 500 µm und 1000 µm. Der Damm wird dabei entweder unmittelbar auf der Modulplatte gebildet, beispielsweise durch das Auftragen und das Ausgehärten eines geeigneten Materials (durch ein sogenanntes Dispensverfahren) oder der Damm wird zunächst als separates Bauteil hergestellt das anschließend mit der Modulplatte verbunden wird. Weiterhin ist es bevorzugt, dass der Damm mit einer hauptsächlich diffus reflektierenden weißen Oberfläche ausgebildet ist oder mit einer spiegelnden metallischen Oberfläche. Vorteilhafterweise sind innerhalb des durch den zumindest einen umschließenden Damms des zumindest einen Lichtfelds keine weiteren Dämme mehr vorgesehen. Es können allerdings auch mehrere jeweils durch einen Damm begrenzte Lichtfelder auf der Modulplatte vorgesehen werden. Analog zur Bereitstellung des Damms können auch die wulstförmigen Wandungen entweder unmittelbar auf der Modulplatte gebildet werden, beispielsweise durch das Auftragen und das Ausgehärten eines geeigneten Materials (vorzugsweise durch ein sogenanntes Dispensverfahren) oder die wulstförmigen Wandungen werden zunächst als separate Bauteile bzw. als Verbund mit dem Damm hergestellt und anschließend mit der Modulplatte verbunden. Soweit im Bereich der wulstförmigen Wandungen ebenfalls LED-Chips vorgesehen sind, ist es bevorzugt, die wulstförmigen Wandungen unmittelbar auf der Modulplatte zu bilden, da diese in diesem Fall die darunter angeordneten LED-Chips bedecken sollen.

Die durch die Vergussmasse und die wulstförmigen Wandungen gebildete Oberfläche des Lichtfelds kann glatt oder wellig ausgebildet sein. Eine wellige Oberfläche kann sich dabei dadurch ergeben, dass sich entweder die wulstförmigen Wandungen über die in den abgetrennten Bereichen vorgesehene Vergussmassen hinaus erstrecken oder dadurch, dass sich die Vergussmassen über die wulstförmigen Wandungen hinaus erstrecken.

Vorzugsweise ist das durch den zumindest einen Damm umfasste Lichtfeld kreisförmig und weist vorzugsweise eine Lichtstromdichte von > 5 lm/mm² auf woraus sich für ein Lichtstrompacket von 2000 lm ein Durchmesser des Lichtfeldes von etwa 23 mm ergibt. Durch die angewandte Erfindung kann jedoch eine Lichtstromdichte von > 25 lm/mm² erreicht werden, was zu Lichtfelddurchmesser von ca. 16 mm bis etwa 11 mm für ein Lichtstrompacket von 2000 lm führt.

Es ist bevorzugt, dass in dem zumindest einen Lichtfeld LED-Chips angeordnet sind, die ein blaues Lichtspektrum emittieren, wobei es besonders bevorzugt ist, dass nur ein blaues Lichtspektrum emittierende LED-Chips in dem zumindest einem Lichtfeld angeordnet sind und insbesondere keine ein rotes Lichtspektrum emittierenden LED-Chips. Auch kann es bevorzugt sein nur in bestimmten Bereichen des zumindest einen Lichtfelds LED-Chips vorzusehen, die ein blaues Lichtspektrum emittieren. Die vorliegender Erfindung versteht dabei unter Licht aus dem roten Lichtspektrum allgemein Licht mit einer Peak-Wellenlänge zwischen etwa 580 und 670 nm, unter Licht aus dem blauen Lichtspektrum Licht mit einer Peak-Wellenlänge zwischen etwa 390 bis 480 nm, unter Licht aus dem grünen Lichtspektrum mit einer Peak-Wellenlänge zwischen etwa 480 bis 560 nm und unter Licht aus dem gelben Lichtspektrum Licht mit einer Peak-Wellenlänge zwischen 560 und 630 nm.

Vorzugsweise umfasst die in den abgetrennten Bereichen jeweils angeordneten Vergussmasse grünen, gelben oder roten Leuchtstoff oder eine Mischung davon. Ein Leuchtstoff ist dabei allgemein ein Stoff, der durch Licht, das von den verwendeten LED-Chips emittiert werden kann, anregbar ist und daraufhin ein sekundäres Lichtspektrum abgibt. Vorzugsweise werden in der vorliegenden Erfindung anorganische Leuchtstoffe oder auch ein Quantumdot eingesetzt, beispielsweise ZnS, ZnSe, CdS, CdSe, ZnTe, CdTe). Vorzugsweise wird durch den Leuchtstoff sekundäres Licht aus dem gelben, grünen und/oder roten Spektrumbereich abgegeben, wenn die Anregung durch blaues Licht erfolgt, bei Verwendung von tiefblauen Licht (<420 nm) oder UV-Licht ist auch eine Emission von blauen Licht erforderlich. Weitere vorliegend einsetzbare Leuchtstoffe sind zum Beispiel: Silikate (Ca₃Sc₂Si₃O₁₂: Ce3+), Ortho-Silikate (BOSE), Granate (YAG: Ce³⁺, (YGd)AG: Ce³⁺, LuAG: Ce³⁺), Oxides (CaScO₂: Eu²⁺), SiALONs (a-SiALON: Eu²⁺, b-SiALON: Eu²⁺), Nitride (La₃Si₆N₁₁: Ce³⁺, CaAlSiN₃:Ce³⁺), Oxy-Nitride (SrSi₂N₂O₂: Eu²⁺, (Ca,Sr,Ba)Si₂N₂O₂: Eu²⁺).

Vorteilhafterweise sind die wulstförmigen Wandungen im Wesentlichen parallel zueinander auf dem Lichtfeld angeordnet, so dass sich eine alternierende Abfolge von abgetrennten Bereichen und wulstförmigen Wandungen auf dem Lichtfeld ergibt. Eine derartige Ausgestaltung des Lichtfelds stellt eine besonders bevorzugte Ausführungsform der vorliegenden Erfindung dar, da sich dadurch ein besonders homogener Lichteindruck des LED-Moduls erreichen lässt.

In einer bevorzugten ersten Alternative sind LED-Chips sowohl in den durch die jeweiligen Vergussmassen bedeckten Bereichen als auch in den durch die wulstförmigen Wandungen bedeckten Bereichen auf dem Lichtfeld angeordnet, wobei in diesem Fall grüner, gelber oder roter Leuchtstoff oder eine Mischung davon in den wulstförmigen Wandungen angeordnet ist. Auch hier können die bereits oben beschriebenen Leuchtstoffe eingesetzt werden.

Vorteilhafterweise ist der Leuchtstoff in den wulstförmigen Wandungen derart gewählt, dass diese Bereiche ein (warmweißes) Weißlicht mit einer Farbtemperatur zwischen 2500 K und 4000 K, vorzugsweise zwischen 2800 K und 3500 K und besonders bevorzugt von etwa 3000 K abgeben; und wobei der Leuchtstoff in den abgetrennten Bereichen derart gewählt ist, dass diese Bereiche ein (kaltweißes) Weißlicht mit einer Farbtemperatur zwischen 4500 K und 8000 K, vorzugsweise zwischen 5000 K und 7500 K und besonders bevorzugt von etwa 6500 K abgeben. Dabei ist es besonders bevorzugt, dass die LED-Chips, die jeweils in einem abgetrennten Bereich und die LED-Chips, die jeweils in den Bereichen der wulstförmigen Wandungen angeordnet sind, jeweils als LED-Strang miteinander verbunden sind. In diesem Zusammenhang ist es weiterhin bevorzugt, dass die jeweiligen LED-Stränge in Gruppen miteinander verschaltet und ansteuerbar sind. Insbesondere ist es dabei bevorzugt, dass die LED-Stränge, die in den abgetrennten Bereichen angeordnet sind als eine erste Gruppe und die LED-Stränge, die in den Bereichen der wulstförmigen Wandungen angeordnet sind als eine zweite Gruppe miteinander verschaltet und angesteuert werden, so dass das vom LED-Modul abgegebene Weißlicht zwischen der Farbtemperatur der ersten Gruppe und der Farbtemperatur der zweiten Gruppe frei einstellbar ist.

In der Ausgestaltung der bevorzugten ersten Alternative kann das LED-Modul besonders vorteilhaft als OP-Leuchte eingesetzt werden, da der Operateur je nach Bedarf zwischen einem kaltweißen Licht, das sich besonders gut eignet, um Knochen oder dergleichen zu beleuchten und einem warmweißen Licht, das sich besonders gut eignet, um Fleischgewebe zu beleuchten, frei variieren kann.

Insbesondere in der Ausgestaltung als OP-Leuchte sind die spezifischen Farbwiedergabeindizes Ra8 und Rio₉ des LED-Moduls vorzugsweise größer 90 bei 4300 K. Durch die vergleichsweise hohe Farbwiedergabequalität in diesen spezifischen Bereichen eignet sich ein solches LED-Modul besonders gut als OP-Leuchte, da dadurch die Farben von Knochen und Fleischgewebe besonders gut wiedergegeben werden.

In einer bevorzugten zweiten Alternative umfasst das LED-Modul ebenfalls in den wulstförmigen Wandungen als auch in den abgetrennten Bereichen LED-Chips, wobei insgesamt weniger LED-Chips notwendig sind. Erfindungsgemäß umfasst zumindest ein LED-Strang dabei einen Widerstand und zumindest ein LED-Strang keinen Widerstand, wobei im LED-Strang mit dem Widerstand weniger LED-Chips angeordnet sind, als im LED-Strang ohne einen Widerstand, wenn eine bevorzugte Stromdimmung bereitgestellt werden soll. In dieser Alternative sind die wulstförmigen Wandungen transparent ausgebildet.

In dieser Alternative ist der Leuchtstoff bzw. sind die Leuchtstoffmischungen für die abgetrennten Bereiche und die wulstförmigen Wandungen vorzugsweise derart gewählt, dass das LED-Modul ein (warmweißes) Weißlicht mit einer Farbtemperatur zwischen 2000 K und 4000 K, vorzugsweise zwischen 2200 K und 2700 K und besonders bevorzugt von etwa 2700 K abgeben kann.

Es ist dabei besonders bevorzugt, dass die jeweils in einem abgetrennten Bereich und in einer wulstförmigen Wandung angeordneten LED-Chips als LED-Stränge miteinander verbunden sind, wobei die unterschiedlichen LED-Stränge vorzugsweise wiederum in mehreren Gruppen miteinander verschaltet und ansteuerbar sind, jedoch können bei Bedarf auch einzelne LED-Stränge gezielt angesteuert werden.

Vorteilhafterweise sind die jeweiligen LED-Stränge bzw. die miteinander verschalteten Gruppen dabei unabhängig voneinander dimmbar, beispielsweise mittels Stromdimmung. Dadurch besteht die Möglichkeit, das vom LED-Modul abgestrahlte Licht zu dimmen. Insbesondere durch die Kombination der warmweißen Farbtemperatur und der Dimmbarkeit eignet sich ein solches LED-Modul besonders gut zur Beleuchtung von Wohnräumen, da dadurch ein dimmbares und vergleichsweise warmes, gemütliches Licht bereitgestellt werden kann, das vergleichbar ist mit dem Licht einer Glühlampe.

In einer weiteren Ausführungsform des erfindungsgemäßen LED-Moduls sind die mehreren wulstförmigen Wandungen ("Dämme") vorzugsweise zwei wulstförmige Wandungen, die im Wesentlichen parallel zueinander angeordnet sind. Die können lichtundurchlässig, vorzugsweise reflektierend oder teilreflektierend, bspw. weiss ausgestaltet sein.

Sie können durch Dispensen mit folgendem Aushärten aufgebracht sein.

Vorzugsweise bildet der abgetrennte Bereich des Lichtfelds zwischen den zwei wulstförmigen Wandungen einen ersten abgetrennten Bereich und der abgetrennte Bereich zwischen dem (äusseren, vorzugsweise ringförmigen) Damm und einer der beiden wulstförmigen Wandungen bildet einen zweiten abgetrennten Bereich, so dass das Lichtfeld in einen ersten (mittleren, bspw. streifenförmigen) abgetrennten Bereich und zwei zweite (bspw. segmentförmige) abgetrennte Bereiche unterteilt ist.

Der mittlerer abgetrennte Bereich strahlt vorzugsweise weisses Licht mit einer anderen Farbtemperatur ab als die beiden zweiten Bereiche, die vorzugsweise weisses Licht der gleichen Farbtemperatur abstrahlen. Durch Veränderung der relativen Intensität der Strahlung des mittleren Bereichs zu der Intensität der beiden zweiten Bereiche kann somit eine Veränderung ("Dimmen") der resultierenden Farbtemperatur erzielt werden.

Weitern kann die in den abgetrennten Bereichen jeweils angeordnete Vergussmasse grünen, gelben oder roten Leuchtstoff oder eine Mischung davon umfassen, wobei der Leuchtstoff vorzugsweise ein anorganischer Leuchtstoff und/oder ein Quantumdot ist.

Zudem kann der im ersten abgetrennten Bereich vorgesehene Leuchtstoff derart gewählt werden, dass dieser Bereich ein Weißlicht mit einer Farbtemperatur zwischen 2000 K und 4000 K, vorzugsweise zwischen 2200 K und 2700 K abgibt und der Leuchtstoff in den zwei zweiten Bereichen derart gewählt werden, dass diese Bereiche ein Weißlicht mit einer Farbtemperatur von zwischen 4500 K und 8000 K, vorzugsweise zwischen 5000 K und 7500 K und besonders bevorzugt von etwa 6500 K abgeben.

Vorzugsweise kann der Damm mit einer diffus reflektierenden weißen Oberfläche oder mit einer spiegelnden metallischen Oberfläche ausgebildet sein. Dies ermöglicht insbesondere, dass das innerhalb des ersten abgetrennten Bereichs konvertierte Licht nicht von den anderen Bereichen des Lichtfelds absorbiert wird.

Weiterhin kann eine Stromquelle, insbesondere eine Konstantstromquelle, zum Betreiben des LED-Moduls im ersten Bereich innerhalb der Vergussmasse bereitgestellt werden. Dadurch wird eine kompakte Anordnung der Stromquelle zusammen mit den anderen Elementen des LED Moduls erzielt.

Bevorzugt kann eine Lichtfläche des ersten abgetrennten Bereichs 20% - 40% des Lichtfelds ausmachen.

Ein erfindungsgemäßes Verfahren zur Herstellung eines LED-Moduls zur Abgabe von Mischlicht, vorzugsweise von Weißlicht, umfasst zumindest die Merkmale gemäß Anspruch 14.

Ferner betrifft die vorliegende Erfindung eine Leuchtvorrichtung, insbesondere eine OP-Leuchte oder eine dimmbare Leuchte zur Beleuchtung Wohnräumen, die zumindest ein oben beschriebenes LED-Modul umfasst.

### 4. Beschreibung von bevorzugten Ausführungsformen

Diese Offenlegung weist mehrere Ausführungsformen auf. Die erste Ausführungsform ist keine Ausführungsform der beanspruchten Erfindung, und die weitere Ausführungsformen sind Ausführungsformen der beanspruchten Erfindung.

Nachfolgend wird eine detaillierte Beschreibung der Figuren gegeben.

Darin zeigt:
- **Figur 1**: eine schematische Draufsicht auf eine erste Ausführungsform eines LED-Moduls;
- **Figur 2**: eine schematische Querschnittsansicht auf das in Figur 1 gezeigte LED-Modul;
- **Figur 3**: eine schematische Ansicht einer Verschaltung einer zweiten bevorzugten Ausführungsform eines erfindungsgemäßen LED-Moduls; und
- **Figur 4**: eine schematische Ansicht der zweiten bevorzugten Ausführungsform eines erfindungsgemäßen LED-Moduls;
- **Figur 5**: zeigt den Stromverlauf durch die jeweilig verschalteten LED-Stränge
- **Figur 6**: zeigt die CIE-Normvalenzkoordinaten der zweiten bevorzugten Ausführungsform in Abhängigkeit zur Stromdimmung.
- **Figur 7**: zeigt eine weitere Ausführungsform der vorliegenden Erfindung.
- **Figur 8**: zeigt ein Diagramm der korrelierten Farbtemperatur normiert auf ein 100%-iges Dimmlevel in Abhängigkeit vom normierten Dimmlevel.
- **Figur 9**: zeigt ein Diagramm der korrelierten Farbtemperatur zum normierten Dimmlevel.
- **Figur 10**: zeigt den Einfluss von unterschiedlichen Chipeigenschaften auf die Dimmkurve für drei verschieden Chips.
- **Figur 11**: zeigt eine Dimmkurve für einen handelsüblichen blauen LED-Chip im mittleren Leistungsbereich.
- **Figur 12**: zeigt Normvalenzkurven für LES 15 und einem Stand der Technik Produkt.

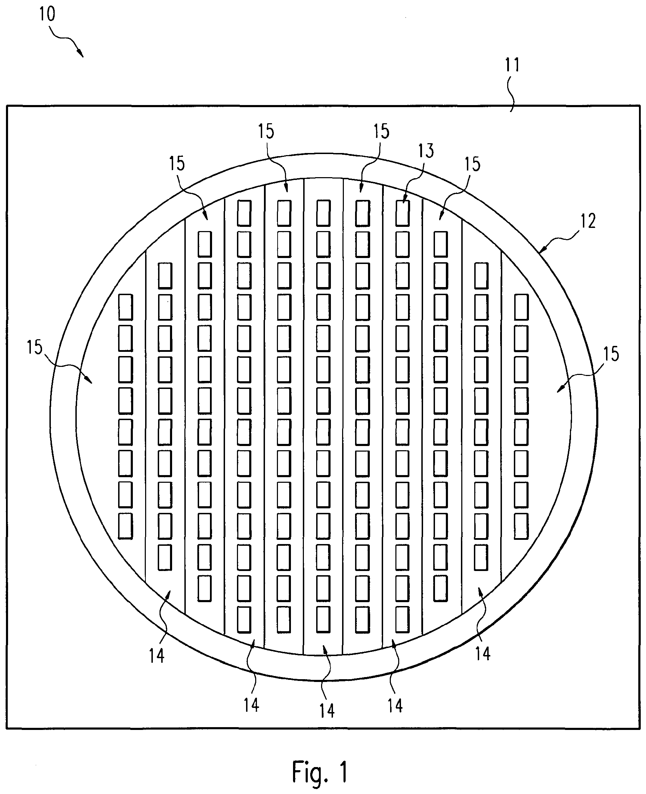

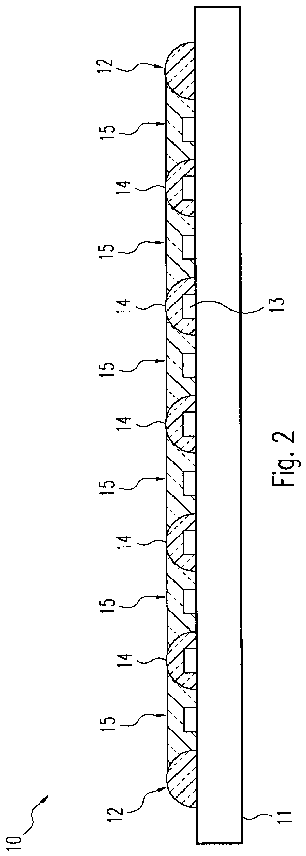

Nachfolgend wird eine erste bevorzugte Ausführungsform eines LED-Moduls 10, das sich besonders gut in der Anwendung als OP-Leuchte eignet, zusammen mit einem bevorzugten Herstellungsverfahren eines solchen LED-Moduls 10 mit Bezug auf die Figuren 1 und 2 erläutert.

In einem ersten Schritt wird eine Modulplatte 11 mit (zumindest) einem Damm 12, der vorzugsweise ein im Wesentlichen kreisförmiges Lichtfeld umgrenzt, bereitgestellt. Innerhalb des Lichtfelds ist eine Vielzahl von LED-Chips 13 angeordneten. Der besseren Übersichtlichkeit halber ist in den Figuren jeweils nur einem LED-Chip exemplarisch ein Bezugszeichen zugeordnet. Wie in Figur 1 gezeigt, ist es bevorzugt, dass die LED-Chips 13 in Reihen und Spalten im Lichtfeld angeordnet sind, so dass eine im Wesentlichen homogene Verteilung der LED-Chips 13 auf dem Lichtfeld erreicht werden kann.

Vorzugsweise weist der Damm 12 eine in Draufsicht gesehene Breite zwischen 50 µm und 2 mm auf. Der Damm 12 kann dabei entweder unmittelbar auf der Modulplatte 11 gebildet werden oder zunächst als separates Bauteil hergestellt werden, das anschließend mit der Modulplatte 11 verbunden wird. Der Damm 12 ist in der gezeigten bevorzugten Ausführungsform mit einer hauptsächlich diffus reflektierenden weißen Oberfläche ausgebildet.

Die LED-Chips 13 sind vorzugsweise blauleuchtende LED-Chips, wobei je nach Anwendung grundsätzlich auch rotleuchtende, grünleuchtende, gelbleuchtende, im UV-Bereich leuchtende LED-Chips oder eine Mischung davon eingesetzt werden können.

In einem weiteren Schritt werden mehrere wulstförmige Wandungen 14 im Lichtfeld aufgebracht. Dies kann beispielsweise durch ein sogenanntes Dispensverfahren erfolgen, wobei die Viskosität des Materials der wulstförmigen Wandungen 14 derart gewählt ist, dass ein ungewolltes Auseinanderlaufen der aufgebrachten wulstförmigen Wandungen 14 verhindert wird.

Wie in Figur 1 gut zu erkennen ist, werden durch die wulstförmigen Wandungen 14 voneinander abgetrennte Bereiche 15 auf dem Leuchtfeld gebildet, die von den jeweiligen Wandungen 14 und dem Damm 12 begrenzt werden. Wie in Figur 1 ebenfalls gut zu erkennen ist, sind in dieser Ausführungsform sowohl in den abgetrennten Bereichen 15 als auch in den Bereichen der Wandungen 14 LED-Chips 13 angeordnet.

Im nächsten Schritt werden die Bereiche 15 mit einer fließfähigen Vergussmasse gefüllt und zwar derart, dass die LED-Chips 13 vollständig von der Vergussmasse bedeckt werden. Die Vergussmasse ist dabei vorzugsweise auf Silikon- und/oder Epoxidbasis gebildet und ist insbesondere im gehärteten Zustand vorzugsweise transparent. Wie in Figur 2 gut zu erkennen ist, sind die Höhen der wulstförmigen Wandungen 14 und die Menge der jeweiligen Vergussmassen derart gewählt, dass sich eine im Wesentlichen *"glatte"* Oberfläche ergibt. Alternativ kann die durch die wulstförmigen Wandungen 14 und die Vergussmassen gebildete Oberfläche allerdings auch *"wellig"* ausgebildet werden, entweder indem sich die wulstförmigen Wandungen 14 über die in den abgetrennten Bereichen 15 vorgesehene Vergussmassen hinaus erstrecken oder dadurch, dass sich die Vergussmassen über die wulstförmigen Wandungen 14 hinaus erstrecken. Alternativ können die wulstförmigen Wandungen 14 auch kleiner ausgeführt werden und zwar derart, dass die fließfähige Vergussmasse die Wandungen 14 komplett überdecken, nicht jedoch den Damm 12.

In der in den Figuren 1 und 2 gezeigten ersten bevorzugten Ausführungsform ist sowohl in der Vergussmasse als auch in den wulstförmigen Wandungen 14 ein Leuchtstoff enthalten. Dabei ist es besonders bevorzugt, wenn der Leuchtstoff in den wulstförmigen Wandungen 14 derart gewählt, dass diese Bereiche (warmweißes) Weißlicht mit einer Farbtemperatur zwischen 2000 K und 4000 K, vorzugsweise zwischen 2500 K und 3500 K und besonders bevorzugt von etwa 3000 K abgeben. Weiterhin ist es besonders bevorzugt, wenn der Leuchtstoff in den abgetrennten Bereichen 15 derart gewählt ist, dass diese Bereiche (kaltweißes) Weißlicht mit einer Farbtemperatur zwischen 8000 K und 5000 K und besonders bevorzugt von etwa 6000K K abgeben.

Vorzugsweise ist in den wulstförmigen Wandungen 14 und in den Vergussmassen jeweils derselbe Leuchtstoff bzw. dieselbe Leuchtstoffmischung eingebracht. Je nach Anwendung besteht allerdings auch die Möglichkeit, in die einzelnen wulstförmigen Wandungen 14 als auch in die jeweiligen Vergussmassen für die abgetrennten Bereiche 15 jeweils unterschiedliche Leuchtstoffe bzw. Leuchtstoffmischungen einzubringen. Wie oben bereits ausgeführt, werden vorliegend vorzugsweise anorganische Leuchtstoffe oder auch ein Quantumdot eingesetzt.

In der gezeigten bevorzugten Ausführungsform sind die LED-Chips 13, die jeweils in einem abgetrennten Bereich 15 und die LED-Chips 13, die jeweils in den Bereichen der wulstförmigen Wandungen 14 angeordnet sind, jeweils als LED-Strang (nicht gezeigt) miteinander verbunden. Dabei sind die LED-Stränge, die in den abgetrennten Bereichen 15 angeordnet sind als eine erste Gruppe und die LED-Stränge, die in den Bereichen der wulstförmigen Wandungen 14 angeordnet sind als eine zweite Gruppe miteinander verschaltet und ansteuerbar. Dadurch kann das vom LED-Modul 10 abgegebene Weißlicht zwischen der Farbtemperatur der ersten Gruppe (kaltweiß) und der Farbtemperatur der zweiten Gruppe (warmweiß) frei eingestellt werden. In dieser Ausgestaltung kann das LED-Modul 10 besonders vorteilhaft in einer OP-Leuchte eingesetzt werden, da der Operateur je nach Bedarf zwischen einem kaltweißen Licht, und einem warmweißen Licht, frei variieren kann und jene Lichtfarbe wählen, die für die jeweils vorhandene chirurgische Aufgabe die besten Sehbedingungen liefert. Vorzugsweise kann durch das LED-Modul 10 eine Lichtstromdichte von > 25 lm/mm² abgegeben werden. In der Praxis wird das abgegebene Licht mit sehr eng bündelden optischen Elementen auf eine kleine Fläche (etwa 10 cm²) projiziert. Ein LED-Modul 10 hat dabei etwa 300 lm und liefert etwa 5000 lx, was beispielsweise in Kombination von 20 Modulen zu einer für OP-Leuchten bevorzugten Bestrahlungsdichte von 100.000 lx führt.

Nachfolgend wird eine zweite bevorzugte Ausführungsform eines LED-Moduls, das sich besonders gut in der Anwendung als dimmbare Leuchte für Wohnräume eignet erläutert.

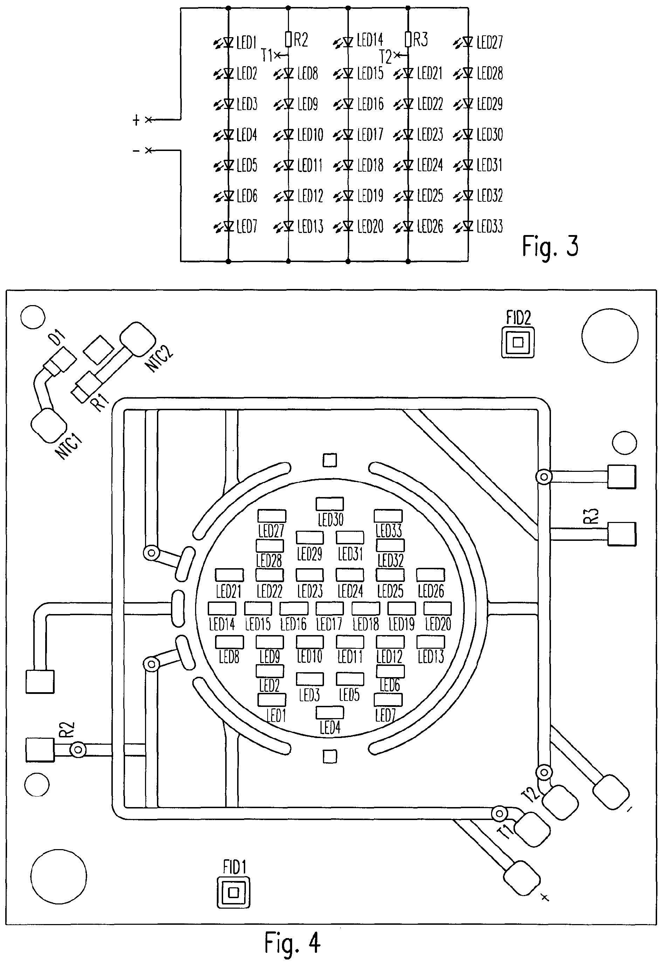

Die Herstellung der zweiten bevorzugten Ausführungsform eines erfindungsgemäßen LED-Moduls erfolgt grundsätzlich in analoger Weise, wie die Herstellung der ersten Ausführungsform des LED-Moduls 10, so dass diesbezüglich auf obige Ausführungen verwiesen wird. Im Unterschied zur ersten Ausführungsform kann die zweite Ausführungsform auch eine geringere Gesamtzahl von LED-Chips aufweisen. Beispielsweise können insgesamt 5 LED-Stränge vorgesehen werden, wobei vorzugsweise 3 LED-Stränge jeweils 7 in Serie geschaltete LED-Chips umfassen und 2 LED-Stränge jeweils 6 in Serie geschaltete LED-Chips (vgl. Figur 3). Auch besteht die Möglichkeit den Stromfluss im Vergleich zum ersten Ausführungsbeispiel zu reduzieren und diesen durch einen entsprechenden Vorwiderstand oder eine Konstantstromquelle zu regeln.

Auch in dieser Ausführungsform werden vorzugsweise nur blauleuchtende LED-Chips verwendet, wobei auch hier, je nach Anwendung, grundsätzlich auch rotleuchtende, grünleuchtende, gelbleuchtende, im UV-Bereich leuchtende LED-Chips oder eine Mischung davon eingesetzt werden können.

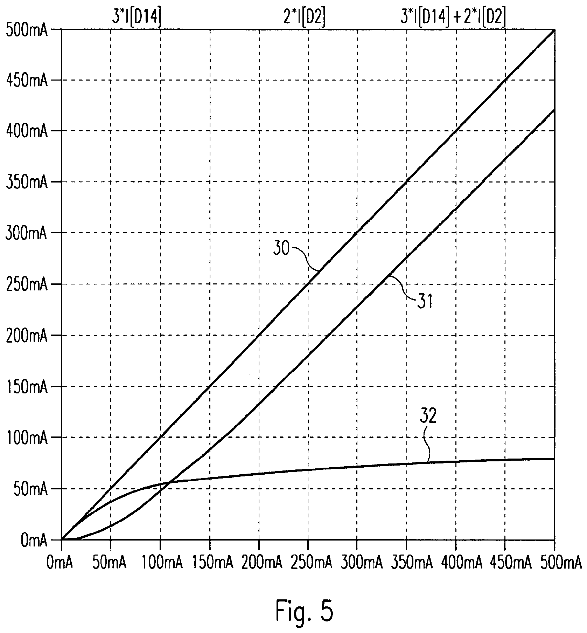

Die Figuren 3 und 4 zeigen eine schematische Ansicht einer elektrischen Verschaltung der LED-Chips der zweiten bevorzugten Ausführungsform, in der das LED-Modul besonders bevorzugt als dimmbare Leuchte verwendet wird. Wie in Figur 3 gut zu erkennen ist, umfasst dieses LED-Modul insgesamt 5 LED-Stränge, wobei 3 LED-Stränge jeweils 7 in Serie geschaltete LED-Chips umfassen und 2 LED-Stränge jeweils 6 in Serie geschaltete LED-Chips Alternative können anstatt der Widerstände R2, R₃, die als Vorwiderstand in den 2 LED-Strängen mit nur 6 in Serie geschalteten LED-Chips angeordnet sind, auch eine oder mehrere Konstantstromquellen eingesetzt werden. Zur Bereitstellung der nachfolgend beschriebenen bevorzugten Regelung ist erforderlich, dass in den 2 LED-Strängen mit den Widerständen weniger LED-Chips in Serie geschalten sind als in den LED-Strängen ohne Widerstände. Figur 5 zeigt die Ströme, die sich bei der in den Figuren 3 und 4 gezeigten Verschaltung ergeben. Der mit dem Bezugszeichen 30 versehene Graph zeigt den Gesamtstrom, der mit dem Bezugszeichen 31 versehene Graph den Strom, der durch die 3 LED-Stränge ohne Widerstände und der mit dem Bezugszeichen 32 versehene Graph den Strom, der durch die 2 LED-Stränge mit den Widerständen fließt. Wie in Figur 5 gezeigt, fließt bei hohen Strömen der Hauptteil durch die 3 Stränge ohne Widerstand. Bei niedrigeren Strömen (Stromdimmung), nimmt der anteilige Strom, der durch die 2 Reihen mit Widerstand fließt stetig zu und bei 100 mA (20% Dimmung) sind beide Anteile etwa gleich groß. Bei 5% Dimmung (25mA) fließt fast ausschließlich Strom durch die 2 LED-Stränge mit Widerstand. Wenn das Summenlicht bei etwa 500mA 2700 K und das Einzellicht der 2 LED-Stränge mit Widerstände 2200 K hat (oder Kerzenlicht mit 1800 K), dann verändert sich durch den Vorgang des Stromdimmens die Lichtfarbe von Glühbirnenlicht auf ein Schummerlicht.

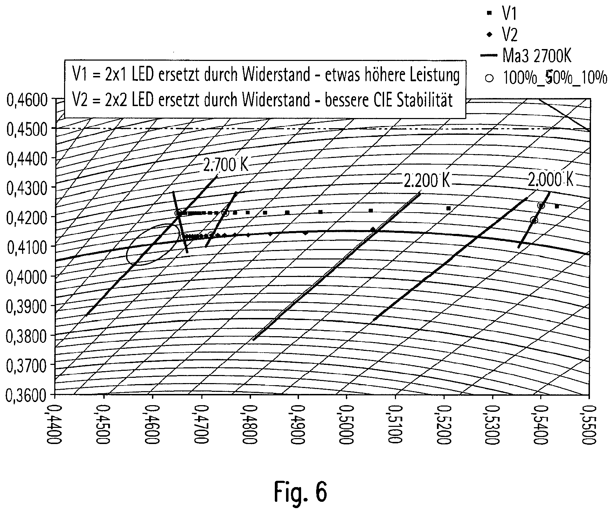

Die Farbtemperaturen können, wie im ersten Ausführungsbeispiel, frei gewählt werden, wobei eine Farbtemperatur zwischen 2700 K auf 2200 K (bzw. 1800K) bevorzugt wird, da dadurch ein Dimmverhalten einer Glühbirnen vergleichbar nachgebildet werden kann. Figur 6 zeigt die CIE-Normvalenzkoordinaten der zweiten bevorzugten Ausführungsform in Abhängigkeit zur Stromdimmung.

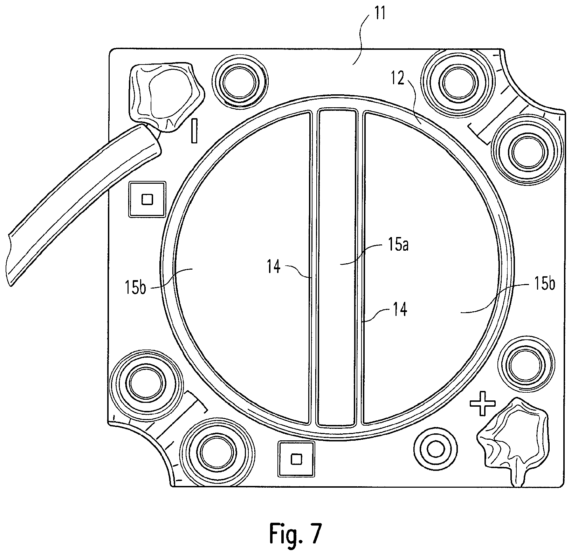

Figur 7 zeigt eine weitere Ausführungsform der Erfindung. Dabei sind innerhalb des Lichtfelds zwei wulstförmige Wandungen 14 bereitgestellt, die im Wesentlichen parallel zueinander verlaufen können. Dabei bildet der Bereich zwischen den zwei wulstförmigen Wandungen 14 einen ersten abgetrennten Bereich 15a und der abgetrennte Bereich zwischen dem Damm 12 und einer der beiden wulstförmigen Wandungen 14 einen zweiten abgetrennten Bereich 15b. Deshalb sind in Figur 7 der erste abgetrennte Bereich 15a und zwei zweite abgetrennte Bereiche 15b zu sehen, wobei der erste abgetrennte Bereich 15a seitlich von jeweils einem zweiten abgetrennten Bereich 15b flankiert wird.

Der Leuchtstoff der in dem ersten abgetrennten Bereich 15a und den beiden zweiten abgetrennten Bereichen 15b vorgesehen ist kann ein grüner, gelber oder roter Leuchtstoff oder eine Mischung davon sein. Dabei kann der Leuchtstoff ein anorganischer Leuchtstoff oder ein Quantumdot sein. Der Leuchtstoff der in dem ersten abgetrennten Bereichs 15a vorgesehen kann dabei derart gewählt werden, dass dieser ein Weißlicht mit einer (warmen) Farbtemperatur zwischen 2000K und 4000K abgibt und der Leuchtstoff in den beiden zweiten Bereichen 15b kann derart gewählt werden, dass diese ein Weißlicht mit einer (im Vergleich dazu kalten) Farbtemperatur zwischen 4500K und 8000K abgibt.

Wie in Figur 7 zu sehen ist, kann dabei der Damm 12 aus einem diffus reflektierendem weißen Oberfläche oder mit einer spiegelnden metallischen Oberfläche ausgebildet sein. Dies verhindert ein Absorbieren des in dem ersten abgetrennten Bereich 15a konvertierten Licht in den anderen Bereichen des Lichtfelds. Zudem ist in Figur 7 eine Konstantstromquelle innerhalb der Vergussmasse im ersten abgetrennten Bereich 15a bereitgestellt. Diese ist in Figur 7 als ein leicht grauer Schatten im oberen Ende des ersten abgetrennten Bereichs 15a zu sehen. Dabei ist die Konstantstromquelle zumindest teilweise in der Vergussmasse eingebettet. Dadurch ergibt sich eine sehr kompakte Anordnung der Stromquelle innerhalb des LED-Moduls.

Weiterhin kann die Fläche des Lichtfeldes des ersten abgetrennten Bereichs 15a 10% - 30%, vorzugsweise 15-25% der gesamten Fläche des Lichtfelds ausmachen, also allgemein kleiner als 50%. Deshalb kann ein Verhältnis der Fläche des Lichtfeldes des ersten abgetrennten Bereichs 15a zu der Fläche des gesamten Lichtfeldes der beiden zweiten abgetrennten Bereiche 15b 1/4 - 2/3 betragen.

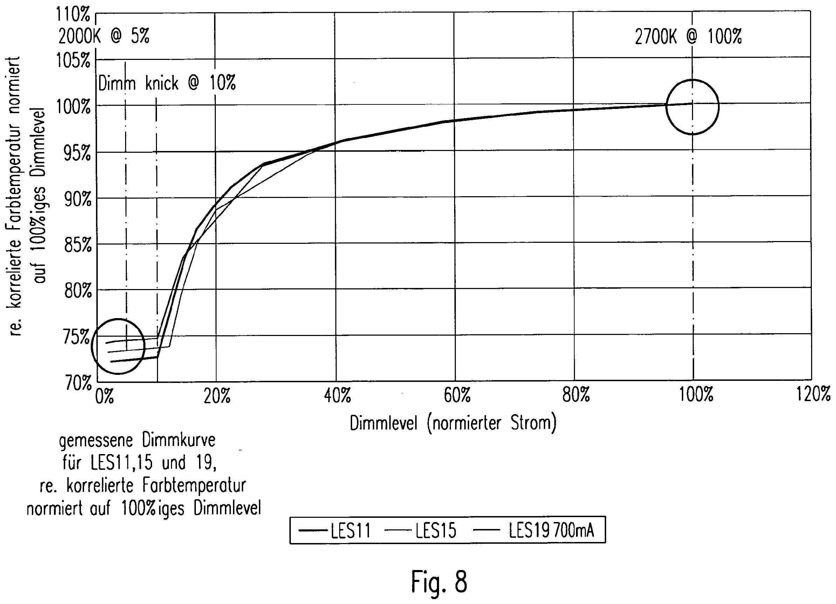

Figur 8 zeigt ein Diagramm, dass die korrelierte Farbtemperatur normiert auf ein 100%-iges Dimmlevel (*re. CCT normalized to 100% dimm level*) in Abhängigkeit von dem normierten Dimmlevel (*Dimm level (normalized current)*) für drei verschiedene Anordnungen von LED-Strängen zeigt. Dabei steht LES 11 für einen LED-Strang mit 9 LED Chips, der im ersten abgetrennten Bereich 15a bereitgestellt ist und 2 LED-Stränge mit jeweils 12 LED Chips, die in den beiden zweiten abgetrennten Bereichen 15b bereitgestellt sind. LES 15 beinhaltet einen LED-Strang mit 9 LED Chips, der im ersten abgetrennten Bereich bereitgestellt ist und 4 LED Stränge mit jeweils 12 LED Chips, die in den beiden zweiten abgetrennten Bereichen 15b bereitgestellt sind. LES 19 beinhaltet 2 LED-Stränge mit jeweils 9 LED Chips, die im ersten abgetrennten Bereich 15a bereitgestellt sind und 6 LED Stränge mit jeweils 12 LED Chips, die in den beiden zweiten abgetrennten Bereichen 15b bereitgestellt sind.

Allgemein kann das Verhältnis der Anzahl der LEDs in einem warmweissen LED-Strang verglichen zu der Anzahl in einem kaltweissen LED-Strang 8:12, 9:12 oder 10:12 betragen. Dieses Verhältnis ist gut für den Wirkungsgrad und das Dimmungsverhalten des entstehenden weissen Lichts.

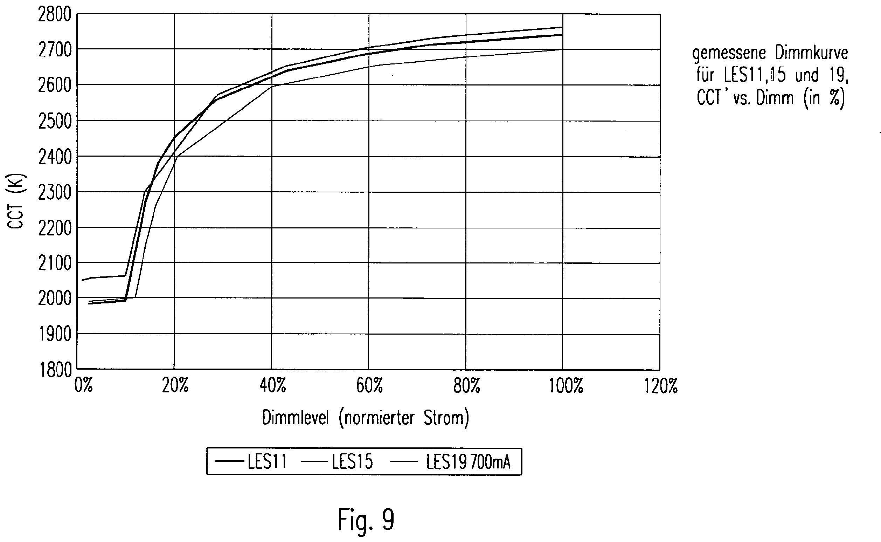

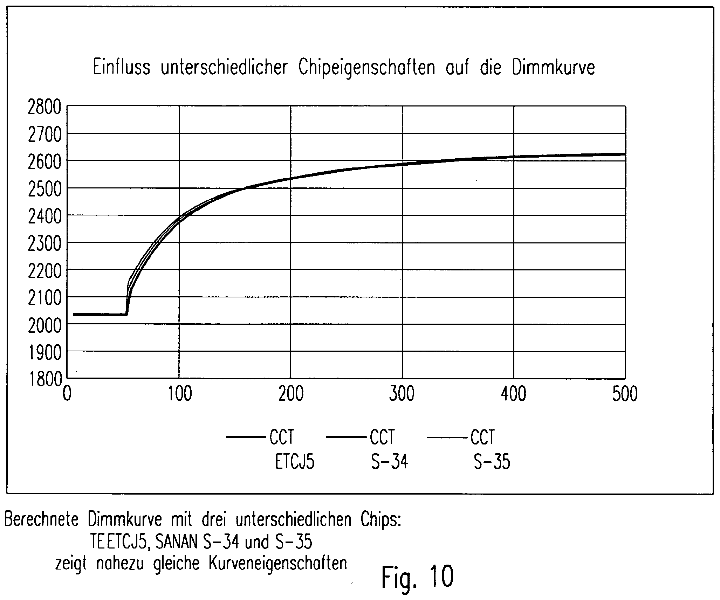

Figur 9 zeigt ein weiteres Diagramm der korrelierten Farbtemperatur *(CCT)* zum normierten Dimmlevel *(Dimm level (normalized current)).* Figur 10 zeigt den Einfluss von unterschiedlichen Chipeigenschaften auf die Dimmkurve für drei verschieden Chips

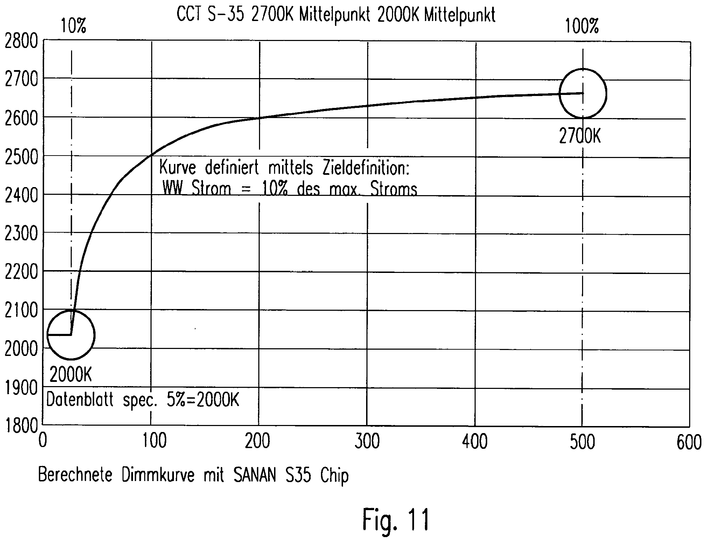

Figur 11 zeigt eine Dimmkurve für einen handelsüblichen LED-Chip im mittleren Leistungsbreich.

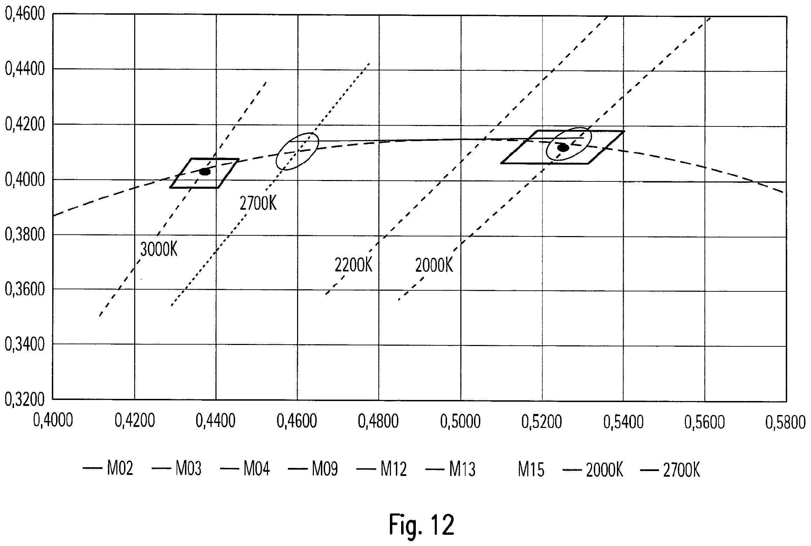

Figur 12 zeigt Normvalenzkurven für LES 15 und einem Stand der Technik Produkt.

Die LED-Chips sind vorzugsweise blau emittierende LED-Chips im mittleren Leistungsbereich von bspw. 0.25 W bis 1 W.

Die vorliegende Erfindung ist nicht auf die vorhergehenden Ausführungsbeispiele beschränkt, solange sie vom Gegenstand der folgenden Ansprüche umfasst ist.

## Patentansprüche

1. LED-Modul (10) zur Abgabe von Mischlicht, vorzugsweise von Weißlicht, umfassend:
- eine Modulplatte (11) mit zumindest einem Damm (12), der zumindest ein Lichtfeld begrenzt, wobei innerhalb des Lichtfelds eine Vielzahl von LED-Chips (13) angeordnet sind;
- wobei innerhalb des Lichtfelds mehrere getrennt zueinander angeordnete, wulstförmige Wandungen (14) vorgesehen sind, die voneinander abgetrennte Bereiche (15) im Lichtfeld ausbilden, wobei der jeweilige wulstförmige Wandungsabschnitt ein Wandungsabschnitt mit einer halbkreisförmigen Querschnittsform ist;
- wobei in den abgetrennten Bereichen (15) jeweils eine Vergussmasse mit einem Leuchtstoff oder einer Leuchtstoffmischung vorgesehen ist; und
- wobei die LED-Chips (13), die jeweils in einem abgetrennten Bereich (15) angeordnet sind, und die LED-Chips (13), die jeweils in den Bereichen der wulstförmigen Wandungen (14) angeordnet sind, jeweils als LED-Strang miteinander verbunden sind, **dadurch gekennzeichnet, dass** zumindest ein LED-Strang einen Widerstand und zumindest ein LED-Strang keinen Widerstand umfasst, wobei im LED-Strang mit dem Widerstand weniger LED-Chips angeordnet sind, als im LED-Strang ohne einen Widerstand.

2. LED-Modul (10) nach Anspruch 1, wobei der Damm (12) eine in Draufsicht gesehene Breite zwischen 50 µm und 2 mm aufweist, bevorzugt zwischen 300 µm und 1,5 mm und weiter bevorzugt zwischen 500 µm und 1000 µm, und wobei der Damm (12) vorzugsweise mit einer hauptsächlich diffus reflektierenden weißen Oberfläche oder mit einer spiegelnden metallischen Oberfläche ausgebildet ist.

3. LED-Modul (10) nach einem der Ansprüche 1 oder 2, wobei in dem zumindest einen Lichtfeld LED-Chips (13) angeordnet sind, die ein blaues Lichtspektrum emittieren, wobei besonders bevorzugt in dem zumindest einen Lichtfeld nur LED-Chips (13) angeordnet sind, die ein blaues Lichtspektrum emittieren.

4. LED-Modul (10) nach einem der vorhergehenden Ansprüche, wobei die in den abgetrennten Bereichen (15) jeweils angeordnete Vergussmasse grünen, gelben oder roten Leuchtstoff oder eine Mischung davon umfassen, wobei der Leuchtstoff vorzugsweise ein anorganischer Leuchtstoff oder ein Quantumdot ist.

5. LED-Modul (10) nach einem der vorhergehenden Ansprüche, wobei die wulstförmigen Wandungen (14) parallel zueinander auf dem Lichtfeld angeordnet sind.

6. LED-Modul (10) nach einem der vorhergehenden Ansprüche, wobei die wulstförmigen Wandungen (14) grünen, gelben oder roten Leuchtstoff oder eine Mischung davon umfassen, wobei der Leuchtstoff vorzugsweise ein anorganischer Leuchtstoff oder ein Quantumdot ist.

7. LED-Modul (10) nach einem der vorhergehenden Ansprüche, wobei
- der Leuchtstoff in den abgetrennten Bereichen (15) derart gewählt ist, dass diese Bereiche ein Weißlicht mit einer Farbtemperatur zwischen 4500 K und 8000 K, vorzugsweise zwischen 5000 K und 7500 K und besonders bevorzugt von etwa 6000 K abgeben; und wobei
- der Leuchtstoff in den wulstförmigen Wandungen (14) derart gewählt ist, dass diese Bereiche ein Weißlicht mit einer Farbtemperatur zwischen 2500 K und 4000 K, vorzugsweise zwischen 3000 K und 3500 K und besonders bevorzugt von etwa 3000 K abgeben.

8. LED-Modul (10) nach einem der vorhergehenden Ansprüche, wobei die jeweiligen LED-Stränge in Gruppen miteinander verschaltet und ansteuerbar sind, wobei vorzugsweise die LED-Stränge, die in den abgetrennten Bereichen (15) angeordnet sind als eine erste Gruppe und die LED-Stränge, die in den Bereichen der wulstförmigen Wandungen (14) angeordnet sind als eine zweite Gruppe miteinander verschaltet und ansteuerbar sind, so dass das vom LED-Modul (10) abgegebene Weißlicht zwischen der Farbtemperatur der ersten Gruppe und der Farbtemperatur der zweiten Gruppe beliebig einstellbar ist.

9. LED-Modul (10) nach Anspruch 8, wobei die jeweils in einem abgetrennten Bereich angeordneten LED-Chips als LED-Stränge miteinander verbunden sind, wobei die unterschiedlichen LED-Stränge vorzugsweise in mehreren Gruppen miteinander verschaltet und ansteuerbar sind,
wobei vorzugsweise die jeweiligen LED-Stränge bzw. die miteinander verschalteten Gruppen unabhängig voneinander dimmbar sind, vorzugsweise mittels Pulsweitenmodulation.

10. LED-Modul (10) nach Anspruch 1, wobei die mehreren wulstförmigen Wandungen (14) zwei wulstförmige Wandungen sind, die parallel zueinander angeordnet sind, wobei vorzugsweise der abgetrennte Bereich (15) des Lichtfelds zwischen den zwei wulstförmigen Wandungen (14) einen ersten abgetrennten Bereich (15a) bildet und der abgetrennte Bereich (15) zwischen dem Damm (12) und einer der beiden wulstförmigen Wandungen (14) einen zweiten abgetrennten Bereich (15b) bildet, so dass das Lichtfeld in einen ersten abgetrennten Bereich (15a) und zwei zweite abgetrennte Bereiche (15b) unterteilt ist,
wobei vorzugsweise die in den abgetrennten Bereichen (15) jeweils angeordnete Vergussmasse grünen, gelben oder roten Leuchtstoff oder eine Mischung davon umfassen, wobei der Leuchtstoff vorzugsweise ein anorganischer Leuchtstoff oder ein Quantumdot ist.

11. LED-Modul (10) nach einem der Ansprüche 9 oder 10, wobei der im ersten abgetrennten Bereich (15a) vorgesehene Leuchtstoff derart gewählt ist, dass dieser Bereich ein Weißlicht mit einer Farbtemperatur zwischen 2000 Kund 4000 K, vorzugsweise zwischen 2200 Kund 2700 K abgibt und der Leuchtstoff in den zwei zweiten Bereichen (15b) derart gewählt ist, dass diese Bereiche ein Weißlicht mit einer Farbtemperatur von zwischen 4500 K und 8000 K, vorzugsweise zwischen 5000 K und 7500 K und besonders bevorzugt von etwa 6500 K abgeben.

12. LED-Modul (10) nach Anspruch 9, wobei eine Stromquelle, insbesondere eine Konstantstromquelle, zum Betreiben des LED-Moduls (10) vorzugsweise im ersten Bereich (15a) innerhalb der Vergussmasse bereitgestellt ist.

13. Leuchtvorrichtung, insbesondere OP-Leuchte oder dimmbare Leuchte, umfassend zumindest ein LED-Modul (10) nach einem der vorhergehenden Ansprüche.

14. Verfahren zur Herstellung eines LED-Moduls (10) zur Abgabe von Mischlicht, vorzugsweise von Weißlicht, umfassend zumindest die folgenden Schritte:
- Bereitstellen einer Modulplatte (11; 110) mit zumindest einem Damm (12), der ein Lichtfeld begrenzt, wobei innerhalb des Lichtfelds eine Vielzahl von LED-Chips (13) angeordnet sind;
- Auftragen mehrerer getrennt zueinander angeordneter, wulstförmiger Wandungen (14) derart, dass der jeweilige wulstförmige Wandungsabschnitt ein Wandungsabschnitt mit einer halbkreisförmigen Querschnittsform ist, und um durch die Wandungen (14) voneinander abgetrennte Bereiche (15) im Lichtfeld auszubilden;
- Füllen der abgetrennten Bereiche (15) jeweils mit einer flüssigen Vergussmasse, wobei die Vergussmasse einen Leuchtstoff oder eine Leuchtstoffmischung umfasst;
- wobei die LED-Chips (13), die jeweils in einem abgetrennten Bereich (15) angeordnet sind, und die LED-Chips (13), die jeweils in den Bereichen der wulstförmigen Wandungen (14) angeordnet sind, jeweils als LED-Strang miteinander verbunden werden, **dadurch gekennzeichnet, dass** zumindest ein LED-Strang einen Widerstand und zumindest ein LED-Strang keinen Widerstand umfasst, wobei im LED-Strang mit dem Widerstand weniger LED-Chips angeordnet sind, als im LED-Strang ohne einen Widerstand.

## Claims

1. LED module (10) for emitting mixed light, preferably white light, comprising:
- a module plate (11) with at least one dam (12), which delimits at least one light field, wherein a plurality of LED chips (13) are arranged within the light field;
- wherein a plurality of bead-shaped walls (14) arranged separately from one another are provided inside the light field and form separated regions (15) in the light field, wherein the respective bead-shaped wall section is a wall section with a semicircular cross-sectional shape;
- wherein a casting compound with a luminescent material or a luminescent material mixture is provided in the respective separated regions (15); and
- wherein the LED chips (13), which are arranged in a respective separated region (15), and the LED chips (13), which are arranged in the respective regions of the bead-shaped walls (14), are respectively connected to one another as LED strands,
**characterized in that** at least one LED strand comprises a resistor and at least one LED strand does not comprise a resistor, wherein fewer LED chips are arranged in the LED strand with the resistor than in the LED strand without a resistor.

2. LED module (10) according to Claim 1, wherein, viewed from the top, the dam (12) has a width between 50 µm and 2 mm, preferably between 300 µm and 1.5 mm, and further preferably between 500 µm and 1,000 µm, and wherein the dam (12) is preferably configured with a mainly diffusely reflecting white surface or with a specular metallic surface.

3. LED module (10) according to any one of Claims 1 or 2, wherein LED chips (13) which emit a blue light spectrum are arranged in the at least one light field, wherein particularly preferably only LED chips (13) which emit a blue light spectrum are arranged in the at least one light field.

4. LED module (10) according to any one of the preceding claims, wherein the casting compound arranged in the respective separated regions (15) comprises green, yellow or red luminescent material, or a mixture thereof, wherein the luminescent material is preferably an inorganic luminescent material or a quantum dot.

5. LED module (10) according to any one of the preceding claims, wherein the bead-shaped walls (14) are arranged parallel to one another on the light field.

6. LED module (10) according to any one of the preceding claims, wherein the bead-shaped walls (14) comprise green, yellow or red luminescent material, or a mixture thereof, wherein the luminescent material is preferably an inorganic luminescent material or a quantum dot.

7. LED module (10) according to any one of the preceding claims, wherein
- the luminescent material in the separated regions (15) is selected such that these regions emit a white light with a color temperature between 4,500 K and 8,000 K, preferably between 5,000 K and 7,500 K and particularly preferably about 6,000 K; and wherein
- the luminescent material in the bead-shaped walls (14) is selected such that these regions emit a white light with a color temperature between 2,500 K and 4,000 K, preferably between 3,000 K and 3,500 K and particularly preferably about 3,000 K.

8. LED module (10) according to any one of the preceding claims, wherein the respective LED strands are interconnected and controllable in groups, wherein the LED strands which are arranged in the separated regions (15) are preferably interconnected and controllable as a first group and the LED strands which are arranged in the regions of the bead-shaped walls (14) are interconnected and controllable as a second group, so that the white light emitted by the LED module (10) can be adjusted between the color temperature of the first group and the color temperature of the second group as desired.

9. LED module (10) according to Claim 8, wherein the LED chips arranged in a respective separated region are connected to one another as LED strands, wherein the different LED strands are preferably interconnected and controllable in a plurality of groups,
wherein the respective LED strands or the interconnected groups are preferably dimmable independently of one another, preferably by means of pulse-width modulation.

10. LED module (10) according to Claim 1, wherein the plurality of bead-shaped walls (14) are two bead-shaped walls arranged parallel to one another,
wherein the separated region (15) of the light field between the two bead-shaped walls (14) preferably forms a first separated region (15a) and the separated region (15) between the dam (12) and one of the two bead-shaped walls (14) forms a second separated region (15b), so that the light field is divided into a first separated region (15a) and two second separated regions (15b),
wherein the casting compound arranged in the respective separated regions (15) preferably comprises green, yellow or red luminescent material, or a mixture thereof, wherein the luminescent material is preferably an inorganic luminescent material or a quantum dot.

11. LED module (10) according to any one of Claims 9 or 10, wherein the luminescent material provided in the first separated region (15a) is selected such that this region emits a white light with a color temperature between 2,000 K and 4,000 K, preferably between 2,200 K and 2,700 K, and the luminescent material in the second separated region (15b) is selected such that these regions emit a white light with a color temperature between 4,500 K and 8,000 K, preferably between 5,000 K and 7,500 K and particularly preferably about 6,500 K.

12. LED module (10) according to Claim 9, wherein a current source, in particular a constant current source, for operating the LED module (10) is preferably provided in the first region (15a) within the casting compound.

13. Lighting device, in particular a surgical light or a dimmable lamp, comprising at least one LED module (10) according to any one of the preceding claims.

14. Method for producing an LED module (10) for emitting mixed light, preferably from white light, comprising at least the following steps:
- providing a module plate (11; 110) with at least one dam (12), which delimits a light field, wherein a plurality of LED chips (13) are arranged within the light field;
- applying a plurality of bead-shaped walls (14) arranged separately from one another such that the respective bead-shaped wall section is a wall section with a semicircular cross-sectional shape, and such that
the walls (14) form separated regions (15) in the light field;
- filling the respective separated regions (15) with a liquid casting compound, wherein the casting compound comprises a luminescent material or a luminescent material mixture;
- wherein the LED chips (13), which are arranged in a respective separated region (15), and the LED chips (13), which are arranged in the respective regions of the bead-shaped walls (14), are respectively connected to one another as LED strands, **characterized in that**
at least one LED strand comprises a resistor and at least one LED strand does not comprise a resistor, wherein fewer LED chips are arranged in the LED strand with the resistor than in the LED strand without a resistor.

## Revendications

1. Module LED (10) destiné à émettre une lumière mixte, de préférence une lumière blanche, comprenant :
- une carte de module (11) pourvue d'au moins un barrage (12) qui limite au moins un champ lumineux, une pluralité de puces LED (13) étant disposées dans le champ lumineux ;
- plusieurs parois en forme de bourrelets (14) séparées les unes des autres étant prévues dans le champ lumineux et formant des zones (15) distinctes les unes des autres dans ledit champ lumineux, chaque tronçon de paroi en forme de bourrelet présentant une forme en section transversale semi-circulaire ;
- une matière de remplissage dotée d'une substance fluorescente ou d'un mélange de substances fluorescentes étant prévue dans chacune des zones distinctes (15) ; et
les puces LED (13) disposées dans chacune des zones distinctes (15) et les puces LED (13) disposées au niveau de chacune des parois en forme de bourrelets (14) étant respectivement reliées entre elles sous la forme d'une chaîne de LED, **caractérisé en ce qu'**au moins une chaîne de LED comprend une résistance et au moins une chaîne de LED ne comprend pas de résistance ; la chaîne de LED à résistance présentant moins de puces LED que la chaîne de LED sans résistance.

2. Module LED (10) selon la revendication 1, dans lequel le barrage (12) présente, vu de dessus, une largeur comprise entre 50 µm et 2 mm, de préférence entre 300 µm et 1,5 mm et plus préférablement entre 500 µm et 1000 µm, et dans lequel le barrage (12) est conçu de préférence avec une surface blanche à effet réfléchissant principalement diffus ou avec une surface métallique à effet miroir.

3. Module LED (10) selon l'une des revendications 1 et 2, dans lequel des puces LED (13) émettant un spectre de lumière bleue sont disposées dans au moins un champ lumineux, plus préférablement dans lequel seules des puces LED (13) émettant un spectre de lumière bleue sont disposées dans au moins un champ lumineux.

4. Module LED (10) selon l'une des revendications précédentes, dans lequel la matière de remplissage disposée dans chacune des zones distinctes (15) comprend une substance fluorescente verte, jaune ou rouge ou un mélange de celles-ci, ladite substance fluorescente consistant de préférence en une substance fluorescente anorganique ou en un point quantique.

5. Module LED (10) selon l'une des revendications précédentes, dans lequel les parois en forme de bourrelets (14) sont disposées parallèlement les unes aux autres sur le champ lumineux.

6. Module LED (10) selon l'une des revendications précédentes, dans lequel les parois en forme de bourrelets (14) comprennent une substance fluorescente verte, jaune ou rouge ou un mélange de celles-ci, ladite substance fluorescente consistant de préférence en une substance fluorescente anorganique ou en un point quantique.

7. Module LED (10) selon l'une des revendications précédentes, dans lequel
- la substance fluorescente présente dans les zones distinctes (15) est choisie de telle façon que ces zones émettent une lumière blanche d'une température de couleur comprise entre 4500 K et 8000 K, de préférence entre 5000 K et 7500 K et plus préférablement d'environ 6000 K, et dans laquelle
- la substance fluorescente présente dans les parois en forme de bourrelets (14) est choisie de telle façon que ces zones émettent une lumière blanche d'une température de couleur comprise entre 2500 K et 4000 K, de préférence entre 3000 K et 3500 K et plus préférablement d'environ 3000 K.

8. Module LED (10) selon l'une des revendications précédentes, dans lequel les chaînes de LED respectives sont interconnectées et pilotables en groupes, les chaînes de LED disposées dans les zones distinctes (15) étant de préférence interconnectées et pilotables sous la forme d'un premier groupe et les chaînes de LED disposées au niveau des parois en forme de bourrelets (14) l'étant sous la forme d'un deuxième groupe, de telle façon que la lumière blanche émise par le module LED (10) soit réglable de manière sélective entre la température de couleur du premier groupe et la température de couleur du deuxième groupe.

9. Module LED (10) selon la revendication 8, dans lequel les puces LED disposées dans chacune des zones distinctes sont reliées entre elles sous la forme de chaînes de LED, les différentes chaînes de LED étant de préférence interconnectées et pilotables en plusieurs groupes,
les chaînes de LED respectives, respectivement les groupes interconnectés étant de préférence gradables indépendamment les uns des autres, de préférence par modulation de largeur d'impulsions.

10. Module LED (10) selon la revendication 1, dans lequel les multiples parois en forme de bourrelets (14) consistent en deux parois en forme de bourrelets parallèles l'une à l'autre, ladite zone distincte (15) du champ lumineux formant de préférence une première zone distincte (15a) entre les deux parois en forme de bourrelets (14), et ladite zone distincte (15) formant de préférence une deuxième zone distincte (15b) entre le barrage (12) et l'une des deux parois en forme de bourrelets (14), de telle façon que le champ lumineux soit subdivisé en une première zone distincte (15a) et une deuxième zone distincte (15b),
ladite matière de remplissage disposée dans chacune des zones distinctes (15) comprenant de préférence une substance fluorescente verte, jaune ou rouge ou un mélange de celles-ci, ladite substance fluorescente consistant de préférence en une substance fluorescente anorganique ou en un point quantique.

11. Module LED (10) selon l'une des revendications 9 et 10, dans lequel la substance fluorescente présente dans la première zone distincte (15a) est choisie de telle façon que cette zone émette une lumière blanche d'une température de couleur comprise entre 2000 K et 4000 K, de préférence entre 2200 K et 2700 K, et la substance fluorescente présente dans les deux deuxièmes zones distinctes (15b) est choisie de telle façon que ces zones émettent une lumière blanche d'une température de couleur comprise entre 4500 K et 8000 K, de préférence entre 5000 K et 7500 K et plus préférablement d'environ 6500 K.

12. Module LED (10) selon la revendication 9, dans lequel une source de courant, notamment de courant constant, est agencée de préférence dans la première zone (15a) à l'intérieur de la matière de remplissage, afin d'alimenter le module LED (10).

13. Dispositif d'éclairage, notamment luminaire de bloc opératoire ou luminaire gradable, comprenant au moins un module LED (10) selon l'une des revendications précédentes.

14. Procédé de fabrication d'un module LED (10) destiné à émettre une lumière mixte, de préférence une lumière blanche, comprenant au moins les étapes suivantes consistant à :
- disposer d'une carte de module (11 ; 110) pourvue d'au moins un barrage (12) qui limite au moins un champ lumineux, une pluralité de puces LED (13) étant disposées dans le champ lumineux ;
- appliquer plusieurs parois en forme de bourrelets (14) séparées les unes des autres de telle façon que chaque tronçon de paroi en forme de bourrelet consiste en un tronçon de paroi présentant une forme en section transversale semi-circulaire, et pour former des zones distinctes (15) dans le champ lumineux sous l'effet desdites parois (14) ;
- remplir les zones distinctes (15) respectivement à l'aide d'une matière de remplissage liquide, ladite matière de remplissage comprenant une substance fluorescente ou un mélange fluorescent ;
- les puces LED (13) disposées dans chacune des zones distinctes (15) et les puces LED (13) disposées au niveau de chacune des parois en forme de bourrelets (14) étant respectivement reliées entre elles sous la forme d'une chaîne de LED ; **caractérisé en ce qu'**au moins une chaîne de LED comprend une résistance et au moins une chaîne de LED ne comprend pas de résistance ; la chaîne de LED à résistance présentant moins de puces LED que la chaîne de LED sans résistance.
